# EUROPEAN PATENT SPECIFICATION

(11) **EP 3 077 910 B1**
(45) Date of publication and mention of the grant of the patent: **11.07.2018**
(21) Application number: 13898887.8
(22) Date of filing: 02.12.2013
(51) Int. Cl.: G06F 11/34, G06F 17/50

(54) **METHODS AND APPARATUS TO OPTIMIZE PLATFORM SIMULATION RESOURCE CONSUMPTION**
VERFAHREN UND VORRICHTUNG ZUR RESSOURCENVERBRAUCHSOPTIMIERUNG IN EINER PLATTFORMSIMULATION
PROCÉDÉS ET APPAREIL POUR OPTIMISER LA CONSOMMATION DE RESSOURCES DE SIMULATION DE PLATEFORME

(43) Date of publication of application: 12.10.2016
(73) Proprietor: Intel Corporation, Santa Clara, CA 95054 (US)
(72) Inventor: MALANI, Parth, Santa Clara, California 95054 (US); TAMHANKAR, Mangesh, Santa Clara, California 95054 (US); JAYARAMAN, Remya, Santa Clara, California 95054 (US)
(74) Representative: Rummler, Felix
(86) International application number: PCT/US2013/072571
(87) International publication number: WO 2015/084297

(56) References cited:
- WO-A1-02/27565
- WO-A1-2006/093762
- WO-A1-2010/045744
- JP-A- 2004 510 258
- US-A1- 2004 215 440
- US-A1- 2008 262 822
- US-A1- 2009 024 381
- US-A1- 2010 325 616

## Description

### FIELD OF THE DISCLOSURE

This disclosure relates generally to hardware simulation and, more particularly, to methods and apparatus to optimize platform simulation resource consumption.

### BACKGROUND

In recent years, software developers have been challenged with developing software applications to run on any number of different hardware platforms. The software developers do not have control over which hardware platforms their customers will use, but the software developers do have control over their code and how that code interacts with one or more unique aspects of a given target platform. However, to verify that a software application performs as expected, the software developer must test the software application on each specific target platform. To minimize hardware expense associated with purchasing every target platform on which the software application is to execute, system simulators may be used to simulate each hardware platform of interest.

From US2008262822 A1 it is known that operational resource modeling is usable to analyze application and computer system performance over a wide range of hypothetical scenarios. Operational resource modeling involves creating and training one or more resource models, and/or simulating hypothetical scenarios using resource models.

According to the present invention, there is proposed an apparatus to optimize a platform simulator according to claim 1, a method to optimize a platform simulator according to claim 6 and a computer readable storage having instructions stored thereon achieving the same according to claim 11.

### BRIEF DESCRIPTION OF THE DRAWINGS

FIG. 1 is a schematic illustration of a simulation environment constructed in accordance with the teachings of this disclosure to optimize platform simulation resource consumption.
FIG. 2 is an example component utilization table constructed in accordance with the teachings of this disclosure.
FIG. 3 is an example simulation agent of FIG. 1 to optimize platform simulation resource consumption.
FIG. 4 is a flowchart representative of example machine readable instructions that may be executed to optimize platform simulation resource consumption in a manner consistent with the teachings of this disclosure.
FIG. 5 is a schematic illustration of an example processor platform that may execute the instructions of FIG. 4 to implement the example simulation agent of FIGS. 1 and 3.

### DETAILED DESCRIPTION

System simulation relates to mimicking behavior of a hardware platform in a software environment. Typically, the system simulator includes a software component to model each corresponding hardware component of the system to be simulated. Hardware components may include, but are not limited to cache memory devices, central processing units (CPUs), graphics processing units (GPUs), disk controllers, memory controllers, peripheral component interconnect (PCI) ports/controllers, universal asynchronous receivers/transmitters (UARTs), northbridge/southbridge chipsets, etc. Each hardware component of interest has an associated software component in the system simulator that, when executing on a computing device, simulates the behavior of the hardware component. Accordingly, software developers do not need to purchase actual hardware platforms for the purpose of developing and/or testing software applications that are to target a platform of interest.

While the system simulator conveniently saves the software developer from substantial capital expenditures associated with separate hardware purchases, simulation duration may become slow as hardware platforms include more complexity and/or greater numbers of individual components that need to be modeled. Because each software component enabled by the system simulator for modeling purposes consumes computing resources from the host machine that is executing the simulator, adding additional software components for a platform naturally results in greater demands upon the host computing device. As a result, a duration of a simulation effort may be prolonged for relatively complex platform simulation efforts.

System simulation may produce results having a degree of accuracy proportionate to how well each hardware component is modeled via a corresponding software component. Accuracy is defined as an error between the simulated or estimated execution state and a corresponding measured value on real hardware of the target platform. On the other hand, system simulation efficiency is defined as an amount of time consumed (e.g., simulation speed) to complete the simulation, which increases as efforts to improve accuracy increase. Accordingly, example methods, systems, apparatus and/or articles of manufacture disclosed herein establish a balance between accuracy and efficiency when performing simulations with system simulators.

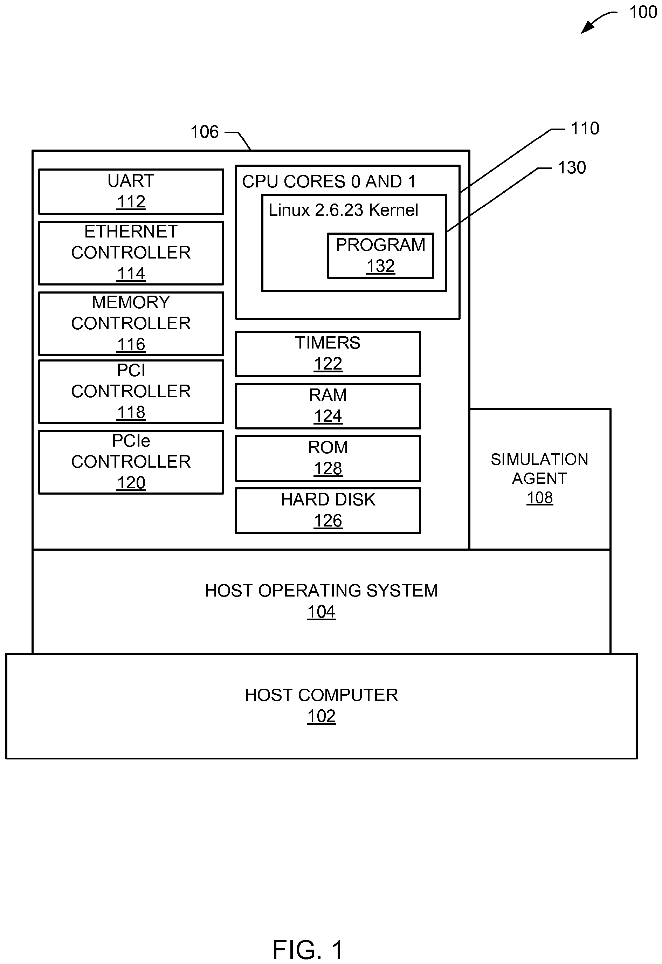

FIG. 1 is a schematic illustration of an example simulation environment 100 implemented in accordance with the teachings of this disclosure to optimize (improve) platform simulation resource consumption. In the illustrated example of FIG. 1, a host computer 102 includes hardware resources for the execution of a host operating system (OS) 104. An example simulation engine 106 (sometimes referred to herein as a "platform simulator") and an example simulation agent 108 execute on the example host OS 104, in which the example simulation engine 106 includes any number of software components (sometimes referred to herein as "simulation components") associated with a platform to be simulated. The example simulation engine 106 components include an example CPU 110, an example UART 112, an example Ethernet controller 114, an example memory controller 116, an example PCI controller 118, an example PCI-express (PCIe) controller 120, example timers 122, example random access memory (RAM) 124, an example hard disk 126 and example read-only memory (ROM) 128. The simulation engine 106 components in the illustrated example of FIG. 1 reflect a platform of interest, while one or more alternate platform(s) of interest may include any number of additional and/or alternate software components.

In operation, the example simulation agent 108 identifies an initial set of simulation components to attach in a simulation. As used herein, the term "attach" refers to enabling one or more simulation components to participate during one or more modeling efforts, while the term "detach" refers to disabling one or more simulation components from participation during one or more modeling efforts. Generally speaking, attaching a greater number of simulation components results in a relatively greater consumption of underlying computing resources (e.g., the host computer 102), while detaching a number of simulation components results in a reduction of the load on the underlying computing resources. The initial set of simulation components may be determined based on examination of a target application and/or operating system that is to be simulated. In the illustrated example of FIG. 1, the simulation engine 106 includes a Linux kernel as the OS 130 and a target program 132 to be simulated.

After a simulation is started, the example simulation agent 108 checks each component that is utilized by the example target program 132 and/or OS 130 (e.g., the target program 132 and/or OS 130 demands and/or otherwise requests functionality from one or more components) to identify a corresponding utilization value. In the event a first simulation component is not initially attached in the simulation (or not currently attached in the simulation), but is later detected as requesting functionality associated with the first simulation component for a threshold resource amount (e.g., a threshold number of clock cycles, a threshold duration of time (milliseconds)), then the requested simulation component is attached by the simulation agent 108 in the simulation. At least one benefit of attaching the example first simulation components in response to identifying a threshold demand is that the accuracy of the simulation will be improved. On the other hand, in the event a second simulation component is currently attached in the simulation, but is detected by the simulation agent 108 as not having utilized a threshold resource amount, then the underutilized simulation component is removed from the simulation. At least one benefit of removing the example second simulation component in response to identifying a lack of a threshold demand is that the load on the underlying resources provided by the example host computer 102 is reduced, thereby improving simulation speed.

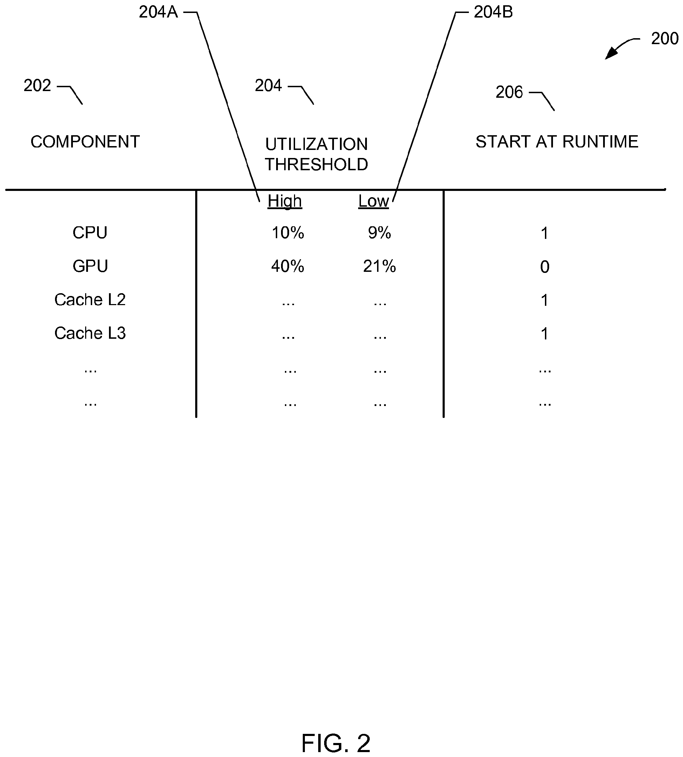

FIG. 2 illustrates an example component utilization table 200 constructed in accordance with the teachings of this disclosure to optimize (improve) platform simulation resource consumption. In the illustrated example of FIG. 2, the table 200 includes a component column 202, a utilization threshold column 204 and a start at runtime column 206. As described in further detail below, a utilization threshold monitor of the example simulation agent 108 compares each simulation component that is currently being utilized by the simulation engine 106 and each simulation component that could be utilized by the simulation engine 106. In other words, the example utilization table 200 may generate a complete list of simulation components, each indicative of actual hardware components demanded by the simulation engine 106, regardless of whether or not such components are currently being utilized during the simulation. In view of the possibility that one or more components may contribute to the simulation in differing amounts at different times during execution of the example OS 130 and/or program 132, the example utilization table 200 includes values to control when to attach or detach one or more simulation components in the example simulation engine 106.

The example component column 202 of FIG. 2 lists any number of hardware components that could be demanded by software executing in a simulation (e.g., the example OS 130 and/or program 132 of FIG. 1). In some examples, each component in the component column 202 includes a corresponding high utilization threshold value 204A and low utilization threshold value 204B. In other examples, each component in the component column 202 includes a single utilization threshold value used for comparison purposes. Additionally, in the event a particular component is to be attached at the time simulation begins (e.g., at time zero of simulation activity), then the example start at runtime column 206 includes a value indicative of true (e.g., a binary value of "1," the term "TRUE," the term "yes," etc.). On the other hand, in the event a particular component is to refrain from being attached at the time simulation begins, then the example start at runtime column 206 includes a value indicative of false (e.g., a binary value of "0," the term "FALSE," the term "no," etc.).

In operation, the example simulation agent 108 monitors a utilization value/demand for each simulation component in the example component column 202 during execution of the simulated platform in the example simulation engine 106. In the event a first simulation component exceeds the example high utilization threshold value (e.g., an upper bound threshold value) 204A, then that corresponding simulation component is attached to the example simulation engine 106, assuming that it was not already attached. On the other hand, in the event the first simulation component falls below the example low utilization threshold value (e.g., a lower bound threshold value) 204B, then that corresponding simulation component is detached from the simulation, assuming that it was not already detached from the example simulation engine 106.

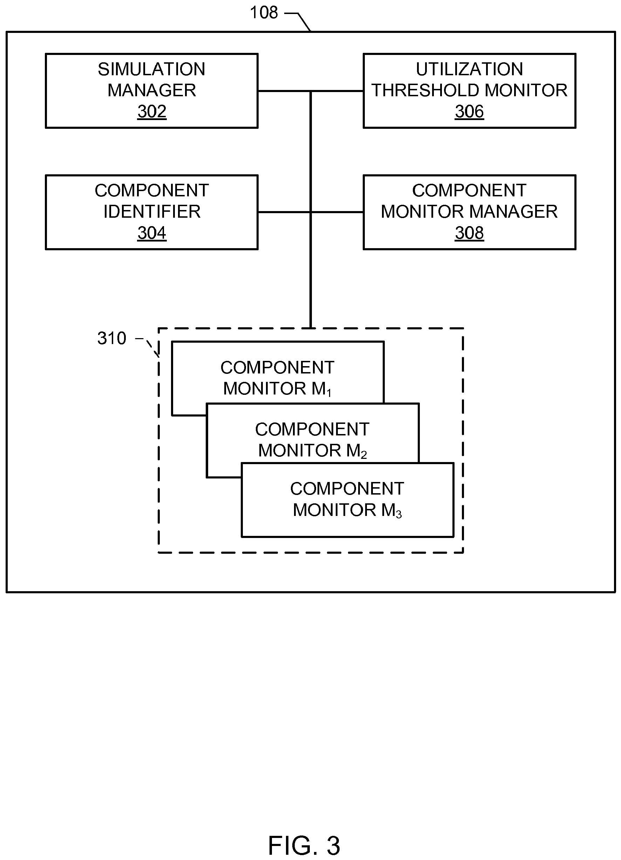

FIG. 3 illustrates the example simulation agent 108 in greater detail. In the illustrated example of FIG. 3, the simulation agent 108 includes a simulation manager 302, a component identifier 304, a utilization threshold monitor 306, a component monitor manager 308, and any number of component monitors M₁, M₂, ..., Mₙ, which are collectively referred to herein as component monitors 310. The quantity of component monitors 310 corresponds to the quantity of hardware components that are being simulated by the example simulation engine 106. For example, component monitor M₁ may be associated with the example UART 112 and monitor its utilization amount (e.g., number of active or demanded CPU cycles per unit of time) throughout the simulation. The example component monitor manager 308 invokes each of the example component monitors 310 on a periodic, aperiodic, scheduled and/or manual basis to identify a utilization value for each corresponding software component. As software components exceed or drop below corresponding utilization thresholds, the example component monitor manager 308 either attaches or detaches corresponding component models to/from the example simulation engine 106 during the simulation.

After the example simulation manager 302 starts the simulation, it determines whether an amount of time has passed to cultivate utilization information associated with each simulated component. For each component of interest, the example utilization threshold monitor 306 determines whether a utilization value (e.g., CPU cycles, percentage of utilization time as a ratio/portion of overall simulation time, etc.) is less than a threshold utilization value associated with the component of interest. As described above, threshold utilization values may be stored in the example component utilization table 200 of FIG. 2. In the event a particular component of interest utilization value is less than a corresponding threshold value, the example component monitor manager 308 determines whether the corresponding component of interest is currently attached. As described above, in the event a component model is attached, but it is not being utilized and/or otherwise demanded by one or more programs of the simulation, then maintaining that component model in the example simulation engine 106 wastes resources of the underlying host computer 102 that could otherwise be utilized for the remaining component(s) that can model the platform of interest. In such circumstances, the example simulation manager 302 halts the simulation and the example component monitor manager 302 detaches the underutilized component model.

On the other hand, in the event the example utilization threshold monitor 306 determines a utilization value of the component of interest is greater than a threshold utilization value associated with that component of interest, then the component monitor manager 308 determines if that component model is currently attached in the simulation engine 106. If not, then attaching the component model of interest to the example simulation engine 106 will model the simulation with a greater degree of accuracy. The example simulation manager 302 halts the running simulation and the example component monitor manager 308 attaches the component model to the example simulation engine 106 before the simulation is restarted.

While an example manner of implementing the simulation agent 108 of FIGS. 1 and 3 is illustrated in FIGS. 1-3, one or more of the elements, processes and/or devices illustrated in FIGS. 1 and 3 may be combined, divided, re-arranged, omitted, eliminated and/or implemented in any other way. Further, the example simulation engine 106, the example simulation manager 302, the example component identifier 304, the example utilization threshold monitor 306, the example component monitor manager 308, the example component monitors 310 and/or, more generally, the example simulation agent 108 of FIGS. 1 and 3 may be implemented by hardware, software, firmware and/or any combination of hardware, software and/or firmware. Thus, for example, any of the example simulation engine 106, the example simulation manager 302, the example component identifier 304, the example utilization threshold monitor 306, the example component monitor manager 308, the example component monitors 310 and/or, more generally, the example simulation agent 108 of FIGS. 1 and 3 could be implemented by one or more analog or digital circuit(s), logic circuits, programmable processor(s), application specific integrated circuit(s) (ASIC(s)), programmable logic device(s) (PLD(s)) and/or field programmable logic device(s) (FPLD(s)). When reading any of the apparatus or system claims of this patent to cover a purely software and/or firmware implementation, at least one of the example simulation engine 106, the example simulation manager 302, the example component identifier 304, the example utilization threshold monitor 306, the example component monitor manager 308, the example component monitors 310 and/or, more generally, the example simulation agent 108 of FIGS. 1 and 3 is/are hereby expressly defined to include a tangible computer readable storage device or storage disk such as a memory, a digital versatile disk (DVD), a compact disk (CD), a Blu-ray disk, etc. storing the software and/or firmware. Further still, the example simulation agent 108 of FIGS. 1 and 3 may include one or more elements, processes and/or devices in addition to, or instead of, those illustrated in FIGS. 1-3, and/or may include more than one of any or all of the illustrated elements, processes and devices.

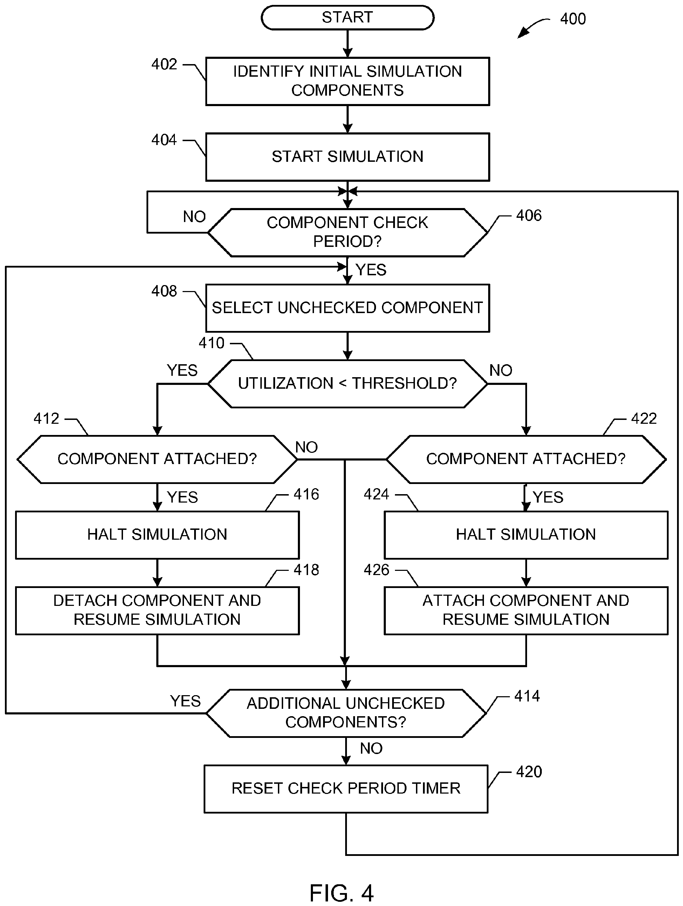

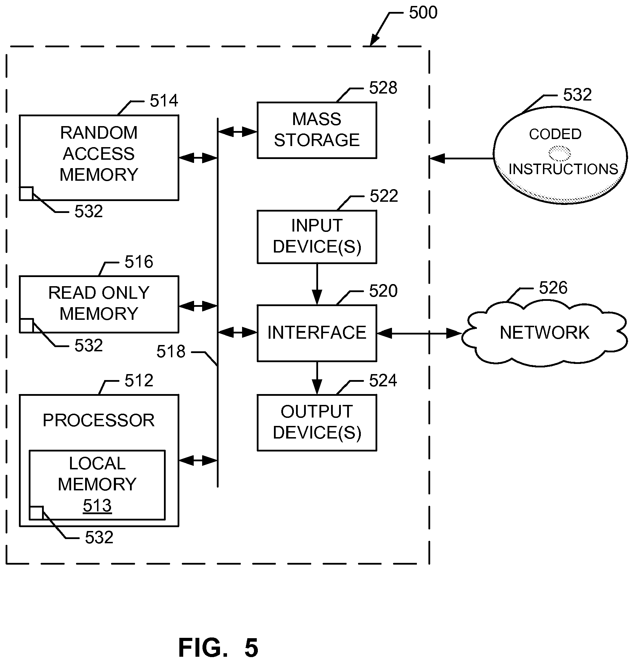

A flowchart representative of example machine readable instructions for implementing the simulation agent 108 of FIGS. 1 and 3 is shown in FIG. 4. In this example, the machine readable instructions comprise a program for execution by a processor such as the processor 512 shown in the example processor platform 500 discussed below in connection with FIG. 5. The program may be embodied in software stored on a tangible computer readable storage medium such as a CD-ROM, a floppy disk, a hard drive, a digital versatile disk (DVD), a Blu-ray disk, or a memory associated with the processor 512, but the entire program and/or parts thereof could alternatively be executed by a device other than the processor 512 and/or embodied in firmware or dedicated hardware. Further, although the example program is described with reference to the flowchart illustrated in FIG. 4, many other methods of implementing the example simulation agent 108 may alternatively be used. For example, the order of execution of the blocks may be changed, and/or some of the blocks described may be changed, eliminated, or combined.

As mentioned above, the example processes of FIG. 4 may be implemented using coded instructions (e.g., computer and/or machine readable instructions) stored on a tangible computer readable storage medium such as a hard disk drive, a flash memory, a read-only memory (ROM), a compact disk (CD), a digital versatile disk (DVD), a cache, a random-access memory (RAM) and/or any other storage device or storage disk in which information is stored for any duration (e.g., for extended time periods, permanently, for brief instances, for temporarily buffering, and/or for caching of the information). As used herein, the term tangible computer readable storage medium is expressly defined to include any type of computer readable storage device and/or storage disk and to exclude propagating signals and to exclude transmission media. As used herein, "tangible computer readable storage medium" and "tangible machine readable storage medium" are used interchangeably. Additionally or alternatively, the example processes of FIG. 4 may be implemented using coded instructions (e.g., computer and/or machine readable instructions) stored on a non-transitory computer and/or machine readable medium such as a hard disk drive, a flash memory, a read-only memory, a compact disk, a digital versatile disk, a cache, a random-access memory and/or any other storage device or storage disk in which information is stored for any duration (e.g., for extended time periods, permanently, for brief instances, for temporarily buffering, and/or for caching of the information). As used herein, the term non-transitory computer readable medium is expressly defined to include any type of computer readable storage device and/or storage disk and to exclude propagating signals and to exclude transmission media. As used herein, when the phrase "at least" is used as the transition term in a preamble of a claim, it is open-ended in the same manner as the term "comprising" is open ended.

The program 400 of FIG. 4 begins at block 402 where the example component identifier 304 examines and/or otherwise parses the example component utilization table 200 to identify initial simulation components to be attached during the simulation performed by the example simulation engine 106. As described above, the example component utilization table 200 of FIG. 2 includes a list of each component of a platform of interest. In the event a component includes an indication of true (e.g., "1," "TRUE," "yes," etc.) in the start at runtime column 206, then the example component monitor manager 308 attaches the corresponding component to the simulation engine 106. On the other hand, in the event a component includes an indication of false (e.g., "0," "FALSE," "no," etc.) in the start at runtime column 206, then the example component monitor manager 308 detaches and/or otherwise confirms the corresponding component is not included in the example simulation engine 106. In some examples, the example component identifier 304 identifies all hardware components that are associated with a given platform of interest to be simulated. Based on the identified hardware components of the platform of interest, the example utilization threshold monitor 306 generates a list having corresponding utilization values for each component model, as described above and shown in FIG. 2.

After the example component monitor manager 308 configures the example simulation engine 106 to attach and detach corresponding components in a manner consistent with the example component utilization table 200 (block 402), the example simulation manager 302 starts the simulation (block 404). The example simulation manager 302 includes a timer to determine when to check all the components of a selected platform of interest for their corresponding utilization values (block 406). For example, the simulation manager 302 may perform an analysis of all components after a threshold number of CPU cycles, a threshold time duration (e.g., every 500 milliseconds) and/or in response to one or more simulation events. Simulation events may include, but are not limited to, instances when the simulated application (e.g., the simulated OS 130, the simulated program 132, etc.) makes a request for a component not previously utilized. For example, in response to a first instance in which the example Ethernet controller 116 is invoked by the simulated application, the example simulation manager 302 may perform the analysis of all platform components to determine one or more utilization values associated therewith.

When the example simulation manager determines that the platform components should be checked (block 406), the example component monitor manager 308 begins a component analysis iteration by selecting one of any number of platform components that has not yet been checked (block 408). As used herein, a component analysis iteration refers to evaluating every component of the current simulation platform (e.g., an x86 CPU running a Windows OS) per check period. In some examples, one or more components may not be included in an analysis iteration due to a negligible effect on the overall performance of the simulation.

After the example component monitor manager 308 selects a component that has not yet been checked for the analysis iteration (block 408), the example utilization threshold monitor 306 determines whether the component of interest utilization value is less than a threshold value, such as a threshold value established by the example component utilization table 200 of FIG. 2 (block 410). If the component of interest utilization value is less than the threshold (block 410), then the example component monitor manager 308 determines whether the component of interest is currently attached in the simulation engine 106 (block 412). If not, then the example simulation engine 106 is already optimized (improved) with regard to that component of interest because it is neither being requested by an executing application(s) nor unnecessarily consuming resources of the underlying host computer 102. In that case, the example component monitor manager 302 determines whether additional components of the platform of interest remain unchecked (block 414). If so, then control returns to block 408 to select another component of interest.

However, in the event the component of interest utilization value is less than the threshold utilization value associated thereto (block 410) and that particular component of interest is currently attached in the simulation engine 106 (block 412), then the example simulation manager 302 halts the simulation (block 416). While the simulation is halted and/or otherwise paused (block 416), the example component monitor manager 308 detaches the component of interest from the example simulation engine 106 (block 418). The result of detaching the component of interest that is not being requested and/or otherwise demanded by one or more executing applications of the simulation is that the underlying host computer 102 is relieved of providing processing resources for that underlying component. As a result, the simulation may proceed in a more efficient manner by allowing the underlying host computer 102 to dedicate its resources to one or more other components that are currently being demanded by the application(s) of the simulation. After the example component monitor manager 308 detaches the unneeded component and resumes the simulation (block 418), it determines whether additional components of the platform of interest remain unchecked for their corresponding utilization value (block 414). If all the components of the platform have been checked to determine their current utilization values (block 414), the example simulation manager 302 resets a check period timer before permitting another iteration to be initiated (block 420). Control then returns to block 406 to determine when another component analysis iteration should begin.

In the event the example utilization threshold monitor 306 detects and/or otherwise identifies that the component of interest utilization value is greater than a corresponding threshold value (block 410), then the example component monitor manager 308 determines whether the component of interest is currently attached in the example simulation engine 106 (block 422). If the component of interest is currently attached (block 422), then the example simulation engine 106 is optimized because the component is active at the same time as one or more requests for that component from one or more executing application(s) (e.g., the example OS 130 and/or the example program 132 of FIG. 1). Control then advances to block 414 where the example component monitor manager 302 determines whether additional components of the platform of interest remain unchecked. However, if the component monitor manager 308 determines that the component of interest is not currently attached to the simulation engine 106 (block 422), then the example simulation manager 302 halts the simulation (block 424). While the simulation is halted and/or otherwise paused (block 424), the example component monitor manager 308 attaches the component of interest to the example simulation engine 106 and resumes the simulation activity (block 426). As a result, the simulation is further optimized by including the software component being demanded by one or more programs executing in the simulation environment 106.

FIG. 5 is a block diagram of an example processor platform 500 capable of executing the instructions of FIG. 4 to implement the simulation agent 108 of FIGS. 1 and 3. The processor platform 500 can be, for example, a server, a personal computer, an Internet appliance, a gaming console, a set top box, or any other type of computing device.

The processor platform 500 of the illustrated example includes a processor 512. The processor 512 of the illustrated example is hardware. For example, the processor 512 can be implemented by one or more integrated circuits, logic circuits, microprocessors or controllers from any desired family or manufacturer.

The processor 512 of the illustrated example includes a local memory 513 (e.g., a cache). The processor 512 of the illustrated example is in communication with a main memory including a volatile memory 514 and a non-volatile memory 516 via a bus 518. The volatile memory 514 may be implemented by Synchronous Dynamic Random Access Memory (SDRAM), Dynamic Random Access Memory (DRAM), RAMBUS Dynamic Random Access Memory (RDRAM) and/or any other type of random access memory device. The non-volatile memory 516 may be implemented by flash memory and/or any other desired type of memory device. Access to the main memory 514, 516 is controlled by a memory controller.

The processor platform 500 of the illustrated example also includes an interface circuit 520. The interface circuit 520 may be implemented by any type of interface standard, such as an Ethernet interface, a universal serial bus (USB), and/or a PCI express interface.

In the illustrated example, one or more input devices 522 are connected to the interface circuit 520. The input device(s) 522 permit(s) a user to enter data and commands into the processor 1012. The input device(s) can be implemented by, for example, a keyboard, a button, a mouse, a touchscreen, a track-pad, a trackball, and/or a voice recognition system.

One or more output devices 524 are also connected to the interface circuit 520 of the illustrated example. The output devices 524 can be implemented, for example, by display devices (e.g., a light emitting diode (LED), an organic light emitting diode (OLED), a liquid crystal display, a cathode ray tube display (CRT), a touchscreen, a tactile output device, a light emitting diode (LED), a printer and/or speakers). The interface circuit 520 of the illustrated example, thus, typically includes a graphics driver card, a graphics driver chip or a graphics driver processor.

The interface circuit 520 of the illustrated example also includes a communication device such as a transmitter, a receiver, a transceiver, a modem and/or network interface card to facilitate exchange of data with external machines (e.g., computing devices of any kind) via a network 526 (e.g., an Ethernet connection, a digital subscriber line (DSL), a telephone line, coaxial cable, a cellular telephone system, etc.).

The processor platform 500 of the illustrated example also includes one or more mass storage devices 528 for storing software and/or data. Examples of such mass storage devices 528 include floppy disk drives, hard drive disks, compact disk drives, Blu-ray disk drives, RAID systems, and digital versatile disk (DVD) drives.

The coded instructions 532 of FIG. 4 may be stored in the mass storage device 528, in the volatile memory 514, in the non-volatile memory 516, and/or on a removable tangible computer readable storage medium such as a CD or DVD.

From the foregoing, it will be appreciated that the above disclosed methods, apparatus, systems and articles of manufacture reduce and/or eliminate computational waste of a host computing platform when performing simulations of target platforms and application(s) executing thereon. While including software component models for each and every corresponding hardware component of a target platform of interest may result in a relatively accurate simulation of how software under test might perform on actual platform hardware, such inclusion of all software component models throughout the entire simulation effort is wasteful when one or more software components are not actually demanded by the executing software. As such, example methods, apparatus, systems and/or articles of manufacture disclosed herein optimize (improve) the application of software component models to instances where their contribution is needed, while removing other software component models when their contribution is not demanded by the executing software.

The following pertain to further examples. An example apparatus to optimize platform simulation resource consumption includes a simulation manager to initiate a simulation on a platform simulator with component models corresponding to hardware components of the platform, a utilization threshold monitor to identify a utilization value associated with a first one of the component models based on a demand caused by a software application under test, and a component monitor manager to attach or detach the first one of the component models to the platform simulator based on a threshold utilization value. Other disclosed example apparatus include the utilization threshold monitor to generate a component utilization table comprising the component models and corresponding threshold utilization values. Still other disclosed example apparatus include the component utilization threshold monitor to track a high utilization threshold value and a low utilization threshold value, in which the component utilization table is to identify whether ones of the component models are to be attached or detached when the simulation begins. Some example disclosed apparatus include the utilization threshold monitor to invoke a corresponding component monitor to identify the utilization value, in which the component monitor is invoked on at least one of a periodic, aperiodic, scheduled or manual basis. Other example disclosed apparatus include the component monitor manager to attach the first one of the component models when the corresponding utilization value exceeds the threshold utilization value, and the first one of the component models is not currently attached to the platform simulator. In some examples, apparatus disclosed herein include the component monitor manager to detach the first one of the component models when the corresponding utilization value is below the threshold utilization value, and when the first one of the component models is currently attached to the platform simulator. Still other disclosed apparatus include the component monitor manager to halt the simulation prior to at least one of attaching or detaching the first one of the component models, and restarting the simulation after at least one of attaching or detaching the first one of the component models.Other disclosed apparatus include the software application under test including at least one of an operating system or an application. Examples disclosed herein further include a threshold utilization value having at least one of an upper bound threshold value or a lower bound threshold value, as well as corresponding component monitors for each hardware component of the platform to identify the utilization values on at least one of a periodic, an aperiodic, a scheduled or a manual basis.

An example method to optimize platform simulation resource consumption includes initiating a simulation on a platform simulator with component models corresponding to hardware components of the platform, identifying a utilization value associated with a first one of the component models based on a demand caused by a software application under test, and attaching or detaching the first one of the component models to the platform simulator based on a threshold utilization value. Additional example disclosed methods include generating a component utilization table comprising the component models and corresponding threshold utilization values, which may further include tracking a high utilization threshold value and a low utilization threshold value and/or identifying whether ones of the component models are to be attached or detached when the simulation begins. Some example disclosed methods include invoking a corresponding component monitor to identify the utilization value, in which invoking the component monitor occurs on at least one of a periodic, aperiodic, scheduled or manual basis. Still other example methods disclosed herein include attaching the first one of the component models when the corresponding utilization value exceeds the threshold utilization value, and when the first one of the component models is not currently attached to the platform simulator. Some example methods disclosed herein include detaching the first one of the component models when the corresponding utilization value is below the threshold utilization value, and when the first one of the component models is currently attached to the platform simulator. Still other example methods disclosed herein include halting the simulation prior to at least one of attaching or detaching the first one of the component models, and restarting the simulation after at least one of attaching or detaching the first one of the component models. Other example methods disclosed herein include simulation of the software application under test as at least one of an operating system or an application. Example disclosed methods also include the threshold utilization value having at least one of an upper bound threshold value or a lower bound threshold value and/or identifying the utilization values on at least one of a periodic, an aperiodic, a scheduled or a manual basis.

An example disclosed computer readable storage medium includes initiating a simulation on a platform simulator with component models corresponding to hardware components of the platform, identifying a utilization value associated with a first one of the component models based on a demand caused by a software application under test, and attaching or detaching the first one of the component models to the platform simulator based on a threshold utilization value. Some example disclosed instructions include generating a component utilization table comprising the component models and corresponding threshold utilization values, in which a high utilization threshold value and/or a low utilization threshold value may be tracked. Still other example disclosed instructions include identifying whether ones of the component models are to be attached or detached when the simulation begins. Some disclosed instructions include invoking a corresponding component monitor to identify the utilization value, in which the corresponding component monitor is invoked on at least one of a periodic, aperiodic, scheduled or manual basis. Other example disclosed instructions include attaching the first one of the component models when the corresponding utilization value exceeds the threshold utilization value, and when the first one of the component models is not currently attached to the platform simulator. Still other example disclosed instructions include detaching the first one of the component models when the corresponding utilization value is below the threshold utilization value, and when the first one of the component models is currently attached to the platform simulator. Additional examples disclosed herein include instructions to halt the simulation prior to at least one of attaching or detaching the first one of the component models, and restarting the simulation after at least one of attaching or detaching the first one of the component models. In some examples disclosed herein, the instructions include simulating at least one of an operating system or an application, applying the threshold utilization value as at least one of an upper bound threshold value or a lower bound threshold value, and/or identifying the utilization values on at least one of a periodic, an aperiodic, a scheduled or a manual basis.

An example disclosed system to optimize platform simulation resource consumption includes means for initiating a simulation on a platform simulator with component models corresponding to hardware components of the platform, means for identifying a utilization value associated with a first one of the component models based on a demand caused by a software application under test, and means for attaching or detaching the first one of the component models to the platform simulator based on a threshold utilization value. Some disclosed systems include means for generating a component utilization table comprising the component models and corresponding threshold utilization values, which may further include means for tracking a high utilization threshold value and a low utilization threshold value and/or means for identifying whether ones of the component models are to be attached or detached when the simulation begins. Still other example disclosed systems include means for invoking a corresponding component monitor to identify the utilization value, which may further include means for invoking the component monitor on at least one of a periodic, aperiodic, scheduled or manual basis. Some example disclosed systems include means for attaching the first one of the component models when the corresponding utilization value exceeds the threshold utilization value, and when the first one of the component models is not currently attached to the platform simulator. Other example disclosed systems include means for detaching the first one of the component models when the corresponding utilization value is below the threshold utilization value, and when the first one of the component models is currently attached to the platform simulator. In other examples, the disclosed system includes means for halting the simulation prior to at least one of attaching or detaching the first one of the component models, and restarting the simulation after at least one of attaching or detaching the first one of the component models. Still other example disclosed systems include means for simulating at least one of an operating system or an application.

Although certain example methods, apparatus and articles of manufacture have been disclosed herein, the scope of coverage of this patent is not limited thereto. On the contrary, this patent covers all methods, apparatus and articles of manufacture fairly falling within the scope of the claims of this patent.

## Claims

1. An apparatus to optimize a platform simulator, comprising:
a simulation manager (302) to initiate a simulation on a platform simulator with component models corresponding to hardware components of the platform; an utilization threshold monitor (306) to identify a utilization value associated with a first one of the component models based on a demand caused by a software application under test; and
a component monitor manager (308) to attach or detach the first one of the component models to the platform simulator based on a comparison of the utilization value to a threshold utilization value.

2. An apparatus as defined in claim 1, wherein the utilization threshold monitor (306) is to generate a component utilization table (200) comprising the component models and corresponding threshold utilization values.

3. An apparatus as defined in claim 1, wherein the component monitor manager (308) is to attach the first one of the component models when:
the utilization value exceeds the threshold utilization value; and
the first one of the component models is not currently attached to the platform simulator.

4. An apparatus as defined in claim 1, wherein the component monitor manager (308) is to detach the first one of the component models when:
the utilization value is below the threshold utilization value; and
the first one of the component models is currently attached to the platform simulator.

5. An apparatus as defined in claims 2, 3 or 4, wherein the threshold utilization value comprises at least one of an upper bound threshold value or a lower bound threshold value.

6. A method to optimize a platform simulator, comprising:
initiating a simulation on a platform simulator with component models corresponding to hardware components of the platform;
identifying an utilization value associated with a first one of the component models based on a demand caused by a software application under test; and
attaching or detaching the first one of the component models to the platform simulator based on a comparison of the utilization value to a threshold utilization value.

7. A method as defined in claim 6, further comprising generating a component utilization table comprising the component models and corresponding threshold utilization values.

8. A method as defined in claim 6, further comprising attaching the first one of the component models when:
the utilization value exceeds the threshold utilization value; and
the first one of the component models is not currently attached to the platform simulator.

9. A method as defined in claim 6, further comprising detaching the first one of the component models when:
the utilization value is below the threshold utilization value; and
the first one of the component models is currently attached to the platform simulator.

10. A method as defined in claim 7, 8 or 9, wherein the threshold utilization value comprises at least one of an upper bound threshold value or a lower bound threshold value.

11. A computer readable storage medium having instructions stored thereon that, when executed, cause a machine to implement a method as defined in claims 6 through 10.

## Patentansprüche

1. Vorrichtung zum Optimieren eines Plattformsimulators, die Folgendes umfasst:
einen Simulationsverwalter (302) zum Initiieren einer Simulation auf einem Plattformsimulator mit Komponentenmodellen, die Hardwarekomponenten der Plattform entsprechen;
einen Nutzungsschwellenmonitor (306) zum Identifizieren eines Nutzungswerts, der mit einem ersten der Komponentenmodelle verknüpft ist, auf Basis eines Bedarfs, der von einer im Test befindlichen Softwareanwendung verursacht wird; und
einen Komponentenmonitorverwalter (308) zum Anbinden oder Trennen des ersten der Komponentenmodelle an den Plattformsimulator auf Basis eines Vergleichs des Nutzungswerts mit einem Nutzungsschwellwert.

2. Vorrichtung nach Anspruch 1, wobei der Nutzungsschwellenmonitor (306) eine Komponentennutzungstabelle (200) erzeugen soll, die die Komponentenmodelle und entsprechende Nutzungsschwellwerte umfasst.

3. Vorrichtung nach Anspruch 1, wobei der Komponentenmonitorverwalter (308) das erste der Komponentenmodelle anbinden soll, wenn:
der Nutzungswert den Nutzungsschwellwert überschreitet und
das erste der Komponentenmodelle derzeit nicht an den Plattformsimulator angebunden ist.

4. Vorrichtung nach Anspruch 1, wobei der Komponentenmonitorverwalter (308) das erste der Komponentenmodelle trennen soll, wenn:
der Nutzungswert unter dem Nutzungsschwellwert liegt und
das erste der Komponentenmodelle derzeit an den Plattformsimulator angebunden ist.

5. Vorrichtung nach Anspruch 2, 3 oder 4, wobei der Nutzungsschwellwert mindestens einen von einem Schwellwert einer oberen Grenze oder einem Schwellwert einer unteren Grenze umfasst.

6. Verfahren zum Optimieren eines Plattformsimulators, das Folgendes umfasst:
Initiieren einer Simulation auf einem Plattformsimulator mit Komponentenmodellen, die Hardwarekomponenten der Plattform entsprechen;
Identifizieren eines Nutzungswerts, der mit einem ersten der Komponentenmodelle verknüpft ist, auf Basis eines Bedarfs, der von einer im Test befindlichen Softwareanwendung verursacht wird; und
Anbinden oder Trennen des ersten der Komponentenmodelle an den Plattformsimulator auf Basis eines Vergleichs des Nutzungswerts mit einem Nutzungsschwellwert.

7. Verfahren nach Anspruch 6, das ferner das Erzeugen einer Komponentennutzungstabelle umfasst, die die Komponentenmodelle und entsprechende Nutzungsschwellwerte umfasst.

8. Verfahren nach Anspruch 6, das ferner das Anbinden des ersten der Komponentenmodelle umfasst, wenn:
der Nutzungswert den Nutzungsschwellwert überschreitet und
das erste der Komponentenmodelle derzeit nicht an den Plattformsimulator angebunden ist.

9. Verfahren nach Anspruch 6, das ferner das Trennen des ersten der Komponentenmodelle umfasst, wenn:
der Nutzungswert unter dem Nutzungsschwellwert liegt und
das erste der Komponentenmodelle derzeit an den Plattformsimulator angebunden ist.

10. Verfahren nach Anspruch 7, 8 oder 9, wobei der Nutzungsschwellwert mindestens einen von einem Schwellwert einer oberen Grenze oder einem Schwellwert einer unteren Grenze umfasst.

11. Computerlesbares Speichermedium, auf dem Anweisungen gespeichert sind, die, wenn sie ausgeführt werden, eine Maschine veranlassen, ein Verfahren nach Anspruch 6 bis 10 durchzuführen.

## Revendications

1. Appareil pour optimiser un simulateur de plate-forme, comportant :
un gestionnaire (302) de simulation servant à lancer une simulation sur un simulateur de plate-forme avec des modèles de composants correspondant à des composants matériels de la plate-forme ;
un moyen (306) de surveillance de seuil d'utilisation servant à identifier une valeur d'utilisation associée à un premier des modèles de composants d'après une demande causée par une application logicielle en cours de test ; et
un gestionnaire (308) de surveillance de composants servant à rattacher ou à détacher le premier des modèles de composants au/du simulateur de plate-forme d'après une comparaison de la valeur d'utilisation à une valeur seuil d'utilisation.

2. Appareil selon la revendication 1, le moyen (306) de surveillance de seuil d'utilisation servant à générer une table (200) d'utilisation de composants comportant les modèles de composants et des valeurs seuils correspondantes d'utilisation.

3. Appareil selon la revendication 1, le gestionnaire (308) de surveillance de composants servant à rattacher le premier des modèles de composants lorsque :
la valeur d'utilisation dépasse la valeur seuil d'utilisation ; et
le premier des modèles de composants n'est pas actuellement rattaché au simulateur de plate-forme.

4. Appareil selon la revendication 1, le gestionnaire (308) de surveillance de composants servant à détacher le premier des modèles de composants lorsque ;
la valeur d'utilisation est inférieure à la valeur seuil d'utilisation ; et
le premier des modèles de composants est actuellement rattaché au simulateur de plate-forme.

5. Appareil selon les revendications 2, 3 ou 4, la valeur seuil d'utilisation comportant au moins une valeur parmi une valeur seuil de borne supérieure et une valeur seuil de borne inférieure.

6. Procédé pour optimiser un simulateur de plate-forme, comportant les étapes consistant à :
lancer une simulation sur un simulateur de plate-forme avec des modèles de composants correspondant à des composants matériels de la plate-forme ;
identifier une valeur d'utilisation associée à un premier des modèles de composants d'après une demande causée par une application logicielle en cours de test ; et
rattacher ou détacher le premier des modèles de composants au/du simulateur de plate-forme d'après une comparaison de la valeur d'utilisation à une valeur seuil d'utilisation.

7. Procédé selon la revendication 6, comportant en outre la génération d'une table d'utilisation de composants comportant les modèles de composants et des valeurs seuils correspondantes d'utilisation.

8. Procédé selon la revendication 6, comportant en outre le rattachement du premier des modèles de composants lorsque :
la valeur d'utilisation dépasse la valeur seuil d'utilisation ; et
le premier des modèles de composants n'est pas actuellement rattaché au simulateur de plate-forme.

9. Procédé selon la revendication 6, comportant en outre le détachement du premier des modèles de composants lorsque :
la valeur d'utilisation est inférieure à la valeur seuil d'utilisation ; et
le premier des modèles de composants est actuellement rattaché au simulateur de plate-forme.

10. Procédé selon la revendication 7, 8 ou 9, la valeur seuil d'utilisation comportant au moins une valeur parmi une valeur seuil de borne supérieure et une valeur seuil de borne inférieure.

11. Support de stockage lisible par ordinateur sur lequel sont stockées des instructions qui, lorsqu'elles sont exécutées, amènent une machine à mettre en oeuvre un procédé selon les revendications 6 à 10.
